# EUROPEAN PATENT APPLICATION

(11) **EP 4 598 287 A1**
(43) Date of publication of application: **06.08.2025**
(21) Application number: 24788388.7
(22) Date of filing: 22.01.2024
(51) Int. Cl.: H05K 3/46, H05K 1/02

(54) **CIRCUIT BOARD, METHOD FOR MANUFACTURING CIRCUIT BOARD, AND ELECTRONIC DEVICE**

(30) Priority: 13.04.2023 JP 2023065702
(71) Applicant: FICT LIMITED, Nagano-shi, Nagano 381-8501 (JP)
(72) Inventor: IIDA, Kenji, Nagano-shi, Nagano 381-8501 (JP); OZAKI, Norikazu, Nagano-shi, Nagano 381-8501 (JP); SAKAI, Taiji, Nagano-shi, Nagano 381-8501 (JP)
(74) Representative: Hoffmann Eitle
(86) International application number: PCT/JP2024/001575
(87) International publication number: WO 2024/214358

(57) **Abstract**

A problem is to provide a circuit board, a method for manufacturing a circuit board, and an electronic device which enables electrical coupling high in reliability without using an adhesive layer. As a solution, it is required to stack a plurality of laminates (30) including a first insulating substrate (14), a metal layer (18) formed on a first surface (14a) of the first insulating substrate (14) to have a pattern, a second insulating substrate (20 (40)) stacked in a place of the first surface (14a) where the metal layer (18) is not disposed so as to have a same thickness as the metal layer (18), a third insulating substrate (22) stacked on a second surface (14b) at an opposite side to the first surface (14a) of the first insulating substrate (14), and a via (26) formed from a surface at an opposite side to the first insulating substrate (14) side of the third insulating substrate (22) until the via (26) reaches the metal layer (18).

## Description

### Technical Field

The present invention relates to a circuit board, a method for manufacturing a circuit board, and an electronic device.

### Background Art

In the past, in order to compactly incorporate electronic components into an electronic device, circuit boards such as printed-wiring boards have widely been used. The printed-wiring board is what is obtained by etching a copper foil attached to a laminated board, in accordance with an electronic circuit pattern, and is difficult to densely mount the electronic components, but is advantageous in terms of cost.

Meanwhile, in accordance with requirements such as a reduction in size, an increase in performance, and a reduction in price to the electronic device, miniaturization of an electronic circuit of a circuit board, an enhancement of multilayer, and an enhancement of high-density packaging of electronic components have rapidly advanced, and studies on the multilayer printed wiring board have been activated with respect to the circuit board.

When manufacturing the multilayer printed wiring board as the circuit board having a multilayer structure, it is performed to make a plurality of insulating substrates provided with wiring patterns laminate each other with adhesive layers. As an example, in PTL 1 (JP-A-2006-66738), a multilayer printed wiring board obtained by stacking a plurality of laminates in which an adhesive resin layer is disposed on a surface at an opposite side to a metal layer with respect to an insulating layer provided with the metal layer shaped like patterns, and vias are formed from the adhesive resin layer to a position of the metal layer, is disclosed.

### Citation List

### Patent Literature

PTL 1: JP-A-2006-66738

### Summary of Invention

### Technical Problem

In the multilayer printed wiring board disclosed in PTL 1, there is a problem that when bonding the metal layer shaped like patterns and protruding from the insulating layer to the adhesive layer or the vias when stacking the laminates on one another, reliability of electrical coupling is deteriorated. Further, in the first place, the adhesive layer is an unnecessary material in the multilayer printed wiring board thus manufactured.

### Solution to Problem

The disclosed technology has an object to provide a circuit board, a method for manufacturing a circuit board, and an electronic device which enables the electrical coupling high in reliability without using the adhesive layer.

In one aspect, a circuit board according to the present case is characterized in that a plurality of laminates which include a first insulating substrate, a metal layer formed on a first surface of the first insulating substrate to have a pattern, a second insulating substrate stacked in a place of the first surface where the metal layer is not disposed so as to have a same thickness as the metal layer, a third insulating substrate stacked on a second surface at an opposite side to the first surface of the first insulating substrate, and a via formed from a surface at an opposite side to the first insulating substrate side of the third insulating substrate until the via reaches the metal layer, is stacked.

In another aspect, a method of manufacturing a circuit board according to the present case is characterized by including a first step of forming a laminate with a metal layer formation step of forming a metal layer on a first surface of a first insulating substrate to have a pattern, a first stacking step, as a subsequent step, of stacking a second insulating substrate to have a same thickness as the metal layer in a place of the first surface where the metal layer is not disposed, to expose a surface of the metal layer, a second stacking step, as a subsequent step, of stacking a third insulating substrate which is uncured and a resin film in this order on a second surface at an opposite side to the first surface of the first insulating substrate, a via formation step, as a subsequent step, of forming a via from a surface at an opposite side to the first insulating substrate side of the third insulating substrate until the via reaches the metal layer, and a separation step, as a subsequent step, of separating the resin film, and a second step of stacking a plurality of the laminates.

In another aspect, an electronic device according to the present case is characterized by including a circuit board according to the disclosure, and an electronic component.

### Advantageous Effects of Invention

In one aspect, it is possible to provide a circuit board capable of achieving electrical coupling high in reliability without using an adhesive layer. In one aspect, it is possible to provide a method for manufacturing a circuit board capable of achieving electrical coupling high in reliability without using an adhesive layer. In one aspect, it is possible to provide an electronic device capable of achieving electrical coupling high in reliability without using an adhesive layer.

### Brief Description of Drawings

Fig. 1 is a schematic cross-sectional view (part 1) showing an example of a method for manufacturing a circuit board.
Fig. 2 is a schematic cross-sectional view (part 2) showing an example of the method for manufacturing the circuit board.
Fig. 3 is a schematic cross-sectional view (part 3) showing an example of the method for manufacturing the circuit board.
Fig. 4 is a schematic cross-sectional view (part 4) showing an example of the method for manufacturing the circuit board.
Fig. 5 is a schematic cross-sectional view (part 5) showing an example of the method for manufacturing the circuit board.
Fig. 6 is a schematic cross-sectional view (part 6) showing an example of the method for manufacturing the circuit board.
Fig. 7 is a schematic cross-sectional view (part 7) showing an example of the method for manufacturing the circuit board.
Fig. 8 is a schematic cross-sectional view (part 8) showing an example of the method for manufacturing the circuit board.
Fig. 9 is a schematic cross-sectional view (part 9) showing an example of the method for manufacturing the circuit board.
Fig. 10 is a schematic cross-sectional view (part 10) showing an example of the method for manufacturing the circuit board.
Fig. 11 is a schematic cross-sectional view (part 11) showing an example of the method for manufacturing the circuit board.
Fig. 12 is a schematic cross-sectional view (part 12) showing an example of the method for manufacturing the circuit board.
Fig. 13 is a schematic cross-sectional view (part 13) showing an example of the method for manufacturing the circuit board.
Fig. 14 is a schematic cross-sectional view (part 14) showing an example of the method for manufacturing the circuit board.
Fig. 15 is a schematic cross-sectional view (part 15) showing an example of the method for manufacturing the circuit board.
Fig. 16 is a schematic cross-sectional view (part 16) showing an example of the method for manufacturing the circuit board.
Fig. 17 is a schematic cross-sectional view (part 17) showing an example of the method for manufacturing the circuit board.
Fig. 18 is a schematic cross-sectional view (part 18) showing an example of the method for manufacturing the circuit board.
Fig. 19 is a schematic cross-sectional view of a semiconductor package.

### Description of Embodiments

A circuit board, a method for manufacturing a circuit board, and an electronic device according to each embodiment will hereinafter be described in detail with reference to the drawings. It should be noted that in all the drawings for describing the embodiments, members having the same function are denoted by the same reference symbols, and redundant description thereof will be omitted in some cases.

### <Method for Manufacturing Circuit Board>

### <<General Outline>>

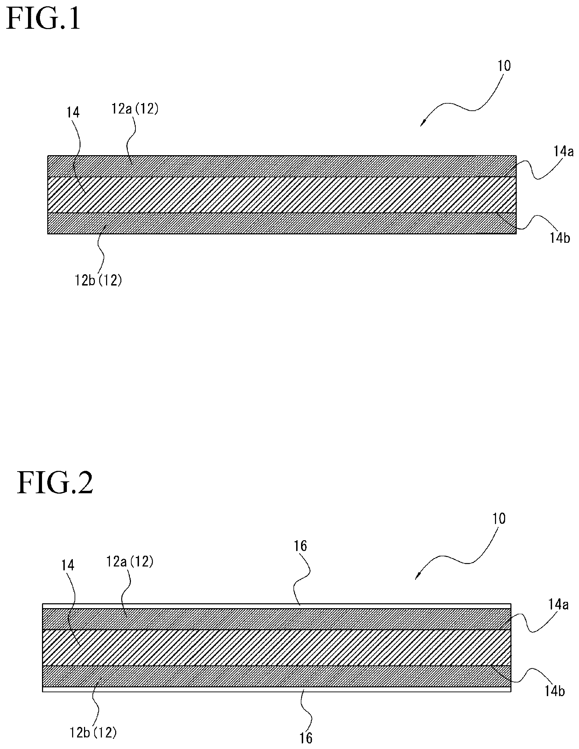

First, the method for manufacturing the circuit board according to the present invention will be described based on Fig. 1 through Fig. 18. The method for manufacturing the circuit board includes at least two steps broadly divided into a first step of forming laminates 30, and a second step of stacking the plurality of laminates 30, and further includes other steps as needed.

Further, the first step includes at least steps including a metal layer formation step, a first stacking step, a second stacking step, a via formation step, and a separation step, and further includes other steps as needed. It should be noted that since a first embodiment and a second embodiment are different from each other only in the first stacking step, the description of other steps than the first stacking step is common to both embodiments, and the first embodiment and the second embodiment are separately described in the description of the first stacking step.

### <<First Step>>

### <<<Metal Layer Formation Step>>>

A metal layer formation step in the first step will be described. In the metal layer formation step, a metal layer 18 shaped like patterns is formed on one surface (referred to as a first surface 14a in some cases) of a first insulating substrate 14.

A method for forming the metal layer 18 shaped like patterns is not particularly limited, but can appropriately be selected in accordance with purposes, and there can be cited, for example, a subtractive (etching) method and a semi-additive method (a plating method). These can be achieved using a photolithography method. Hereinafter, in each of the embodiments, the explanation will be presented as a case when adopting the subtractive (etching) method.

First, as shown in Fig. 1, a three-layered member 10 obtained by sticking metal foil 12 (12a, 12b) to both surfaces of the first insulating substrate 14 is prepared.

The first insulating substrate 14 is not particularly limited as long as the insulating substrate can be used in a circuit board, and can be selected as appropriate in accordance with purposes, and there can be cited, for example, a base material reinforced in hardness with an inorganic base material such as inorganic woven cloth using glass cloth or the like, or inorganic unwoven cloth, or with an organic base material such as an organic woven cloth or organic unwoven cloth.

More specifically, as the first insulating substrate 14, there can be cited, for example, a glass epoxy base material (a glass woven cloth base material impregnated with epoxy resin, a glass unwoven cloth base material impregnated with epoxy resin), a glass woven cloth base material impregnated with bismaleimide triazine resin, an aramid unwoven cloth base material impregnated with epoxy resin, and a glass woven cloth base material impregnated with modified polyphenylene ether resin. Here, the glass epoxy base material means a base material obtained by impregnating a cloth (woven cloth or unwoven cloth) of glass fiber with epoxy resin.

Further, the first insulating substrate 14 has already cured. Here, a state in which something has already cured means a state in which, for example, almost 100 % of the total curing calorific amount has already been generated, and is a state in which, for example, heat generation can hardly be observed when performing the differential scanning calorimetry. The state in which something has already cured is referred to as a C-stage in some cases. Further, a degree of cure which does not reach the C-stage is referred to as a B-stage in some cases.

Further, the first insulating substrate 14 normally has a plate-like shape. An average thickness of the first insulating substrate 14 is not particularly limited, and can appropriately be selected in accordance with purposes, and can be, for example, no smaller than 10 µm and no larger than 200 µm, or can be no smaller than 30 µm and no larger than 100 µm.

The metal foil 12 is not particularly limited, and can appropriately be selected in accordance with purposes, and there can be cited, for example, nickel and copper.

Further, as a structure of the metal foil 12, there can be cited a single layer structure, or can also be cited a multilayer structure. As the metal foil 12, there can be cited, for example, a copper single layer structure and a double layer structure of copper and nickel.

Then, as shown in Fig. 2, a resist 16 is attached to the surfaces of the metal foil 12 (12a, 12b).

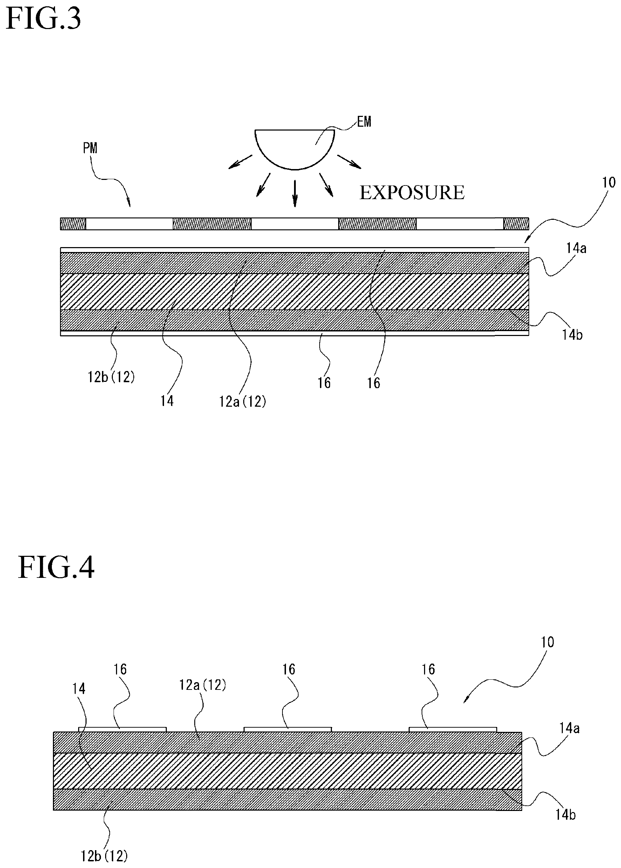

Then, as shown in Fig. 3, by performing exposure with an exposure device EM and then performing development with a development device (not shown), the resist 16 shaped like predetermined patterns is formed on the metal foil 12 as shown in Fig. 4. The exposure is performed only on the metal foil 12a, but is performed on the metal foil 12a for forming the metal layer 18 shaped like patterns via a photomask PM provided with substantially the same pattern as the metal layer 18 which is patterned. Further, the resist 16 on the surface of the metal foil 12b is completely removed by development.

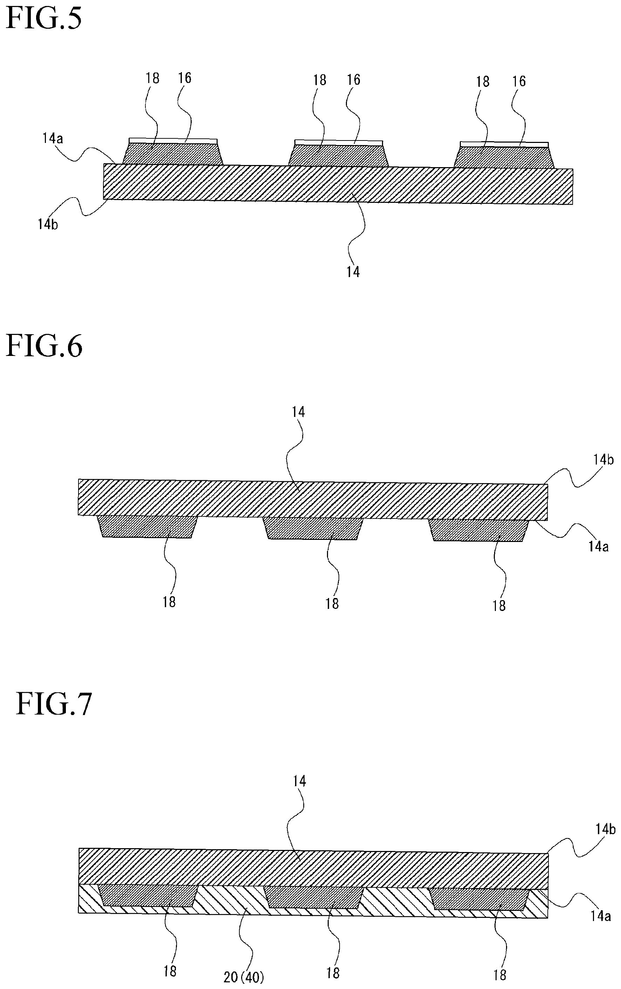

Then, as shown in Fig. 5, the metal layer 18 shaped like patterns is formed by etching.

Then, as shown in Fig. 6, the resist 16 is removed from the surfaces of the metal layers 18 to expose the surfaces of the metal layers 18.

### <<<First Stacking Step (First Embodiment)>>>

Subsequently, the first stacking step according to the first embodiment in the first step will be described. In the first stacking step, in places of the first surface 14a of the first insulating substrate 14 where the metal layer 18 is not disposed, a second insulating substrate 20 is stacked so as to have the same thickness as that of the metal layer 18 (i.e., the same height with reference to the first surface 14a) to expose the surfaces of the metal layers 18.

The second insulating substrate 20 is not particularly limited as long as the insulating substrate can be used in a circuit board, and can be selected as appropriate in accordance with purposes, and it is possible to adopt a photosensitive resin film as the second insulating substrate 20 in the present embodiment. It should be noted that the photosensitive resin film 20 is in an uncured state.

The photosensitive resin film 20 is attached to the metal layer 18, and a state in which the metal layer 18 is tightly covered with the photosensitive resin film 20 as shown in Fig. 7 is obtained using a vacuum lamination device (not shown).

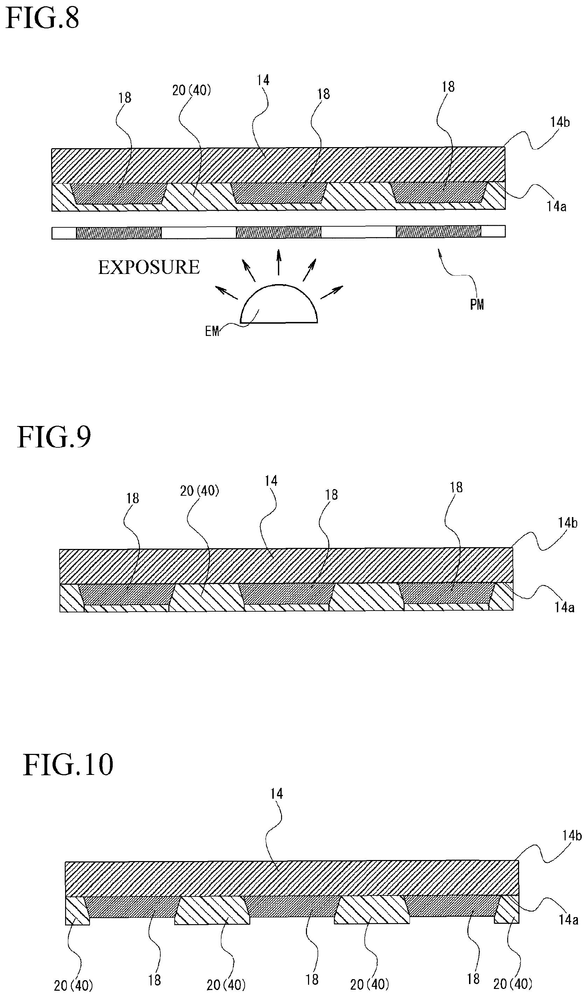

Then, as shown in Fig. 10, the surfaces of the metal layers 18 are exposed from the photosensitive resin film 20. More specifically, first, as shown in Fig. 8, the exposure is performed by the exposure device EM via the photomask PM to form cured areas in the photosensitive resin film 20 as shown in Fig. 9. The cured areas correspond to other places than the surfaces of the metal layers 18 in the plan view in the photosensitive resin film 20, and are areas to be irradiated with UV light in the exposure. Then, heating treatment (tentative cure) is performed using a baking oven (not shown) so that the photosensitive resin film 20 has a predetermined amount of water. Subsequently, by developing the photosensitive resin film 20 with a developing device (not shown), the metal layers 18 are exposed once again with only the photosensitive resin film 20 in the cured areas remaining on the first surface 14a of the first insulating substrate 14. Subsequently, heating treatment (final cure) is performed on the photosensitive resin film 20 with the baking oven so as to further decrease the amount of water.

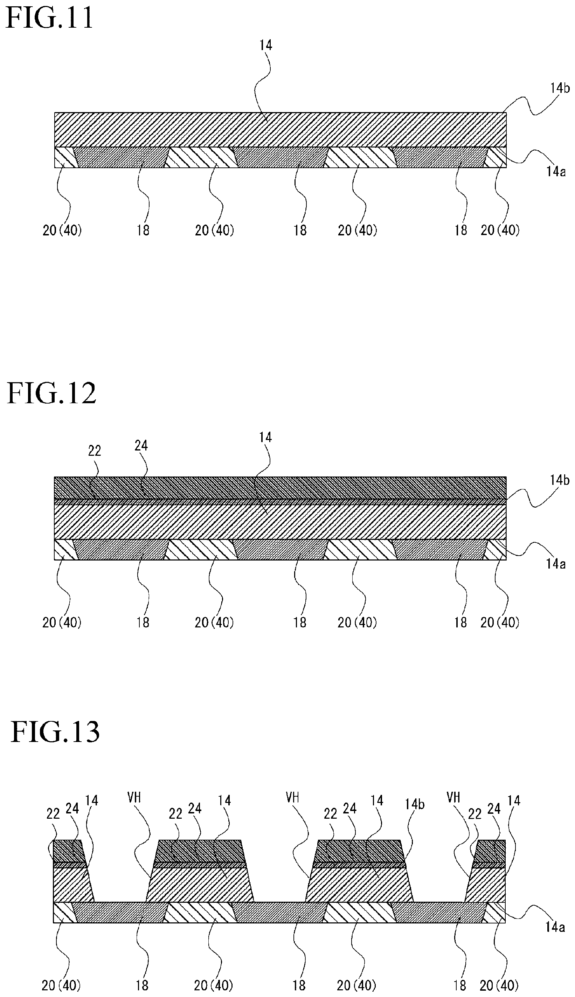

Then, as shown in Fig. 11, the metal layers 18 and the photosensitive resin films 20 are formed so as to be coplanar with each other with a polishing machine (not shown).

### <<<First Stacking Step (Second Embodiment)>>>

Although the photosensitive resin film is adopted as the second insulating substrate 20 in the first embodiment, a photosensitive resin varnish is adopted as a second insulating substrate 40 in the second embodiment. It should be noted that the photosensitive resin varnish 40 in the present embodiment is in an uncured state. The first stacking step when adopting the photosensitive resin varnish 40 is as follows.

As the first stacking step, the photosensitive resin varnish 40 is printed on the metal layer 18 with a screen printer (not shown), and a state in which the metal layer 18 is tightly covered with the photosensitive resin varnish 40 as shown in Fig. 7 is obtained.

Then, as shown in Fig. 10, the surfaces of the metal layers 18 are exposed from the photosensitive resin varnish 40. More specifically, first, as shown in Fig. 8, the exposure is performed by the exposure device EM via the photomask PM to form cured areas in the photosensitive resin varnish 40 as shown in Fig. 9. The cured areas correspond to other places than the surfaces of the metal layers 18 in the plan view in the photosensitive resin varnish 40, and are areas to be irradiated with UV light in the exposure. Then, heating treatment (cure) is performed using a baking oven (not shown) so that the photosensitive resin varnish 40 has a predetermined amount of water. Subsequently, by developing the photosensitive resin varnish 40 with the developing device (not shown), the metal layers 18 are exposed once again with only the photosensitive resin varnish 40 in the cured areas remaining on the first surface of the first insulating substrate 14. It should be noted that in the present embodiment, the heating treatment (cure) to subsequently be performed is not required.

Then, as shown in Fig. 11, the metal layers 18 and the photosensitive resin films 20 are formed so as to be coplanar with each other with a polishing machine (not shown).

It should be noted that the surfaces of the metal layers 18 may be exposed by printing the photosensitive resin varnish 40 on the metal layer 18 with the screen printer (not shown), and then removing the photosensitive resin varnish 40 printed with larger thickness than that of the metal layers 18 with a scraper (not shown).

Due to the first stacking step in either one of the embodiments described above, it is possible to stack the second insulating substrate 20 (40) having the same thickness as that of the metal layers 18 in the place of the first surface 14a of the first insulating substrate 14 where the metal layers 18 are not disposed. By the method for manufacturing the circuit board according to the disclosure including the first stacking step, the surface at the metal layer 18 side in the laminate 30 is flattened, and thus, it is possible to realize electrical coupling high in reliability between vias 26 and the metal layer 18 in the second step described later.

### <<<Surface Roughening Treatment>>>

It should be noted that the method for manufacturing the circuit board in each of the embodiments may include a surface roughening treatment of roughening the surface of the metal layer 18 as a subsequent step to the first stacking step. More specifically, the surface of the metal layer is roughened by a CZ device so that the arithmetic average roughness (Ra) is no lower than 1.0 µm and no higher than 2.0 µm. In other words, the circuit board in the disclosure may be subjected to the surface roughening treatment so that the surface of the metal layer 18 at the second surface 14b side of the first insulating substrate 14 has the arithmetic average roughness (Ra) no lower than 1.0 µm and no higher than 2.0 µm.

Further, an average thickness of the metal layer 18 is not particularly limited, and can appropriately be selected in accordance with purposes, and can be, for example, no smaller than 5 µm and no larger than 40 µm, or can be no smaller than 10 µm and no larger than 30 µm.

### <<<Second Stacking Step>>>

Subsequently, the second stacking step in the first step will be described. In the second stacking step, a third insulating substrate 22 which is uncured and a resin film 24 are stacked in this order on a second surface 14b at an opposite side to the first surface 14a of the first insulating substrate 14.

As shown in Fig. 12, as the second stacking step, the third insulating substrate 22 which is uncured and the resin film 24 are stacked in this order on the second surface 14b of the first insulating substrate 14, and then thermocompression bonding is performed thereon.

The third insulating substrate 22 is not particularly limited as long as the insulating substrate can be used in a circuit board, and can be selected as appropriate in accordance with purposes, and there can be cited, for example, a base material reinforced in hardness with an inorganic base material such as inorganic woven cloth using glass cloth or the like, or inorganic unwoven cloth, or with an organic base material such as an organic woven cloth or organic unwoven cloth.

More specifically, as the third insulating substrate 22, there can be cited, for example, a glass epoxy base material (a glass woven cloth base material impregnated with epoxy resin, a glass unwoven cloth base material impregnated with epoxy resin), a glass woven cloth base material impregnated with bismaleimide triazine resin, an aramid unwoven cloth base material impregnated with epoxy resin, and a glass woven cloth base material impregnated with modified polyphenylene ether resin. Here, the glass epoxy base material means a base material obtained by impregnating a cloth (woven cloth or unwoven cloth) of glass fiber with epoxy resin.

Further, the material of the third insulating substrate 22 may be thermosetting resin. As the thermosetting resin, fluorine resin, polyphenylene ether (PPE/PPO resin), polyimide resin (PI resin), and bismaleimide triazine resin (BT resin) are preferable. These types of resin are each resin which is low in dielectric constant and low in dielectric tangent, and therefore, it is possible to decrease a transmission loss of an electric signal by using these types of resin.

Further, the third insulating substrate 22 normally has a plate-like shape. An average thickness of the third insulating substrate 22 is not particularly limited, and can appropriately be selected in accordance with purposes, and can be, for example, no smaller than 10 µm and no larger than 150 µm, or can be no smaller than 20 µm and no larger than 100 µm.

Further, a ratio between the average thickness of the first insulating substrate 14 and the average thickness of the third insulating substrate 22 ((the first insulating substrate 14):(the third insulating substrate 22)) is not particularly limited, and can appropriately be selected in accordance with purposes, but is preferably in a range of 4.0:1.0 through 1.0:1.0, and is more preferably in a range of 2.0:1.5 through 1.5:1.0 from the viewpoint of the productivity of a circuit board 50 and thickness dimension control.

Further, the resin film 24 is not particularly limited as long as the resin film does not melt in the thermocompression bonding, and can appropriately be selected in accordance with purposes, and there can be cited, for example, a polyethylene terephthalate film, a polyethylene naphthalate film, a polyphenylene sulfite film, and a polyimide film.

Further, a surface at the third insulating substrate 22 side of the resin film 24 is preferably a coarse surface. This makes it possible to further enhance temporary adhesion force between the third insulating substrate 22 and the resin film 24 after the thermocompression bonding to thereby avoid unintended separation between the third insulating substrate 22 and the resin film 24 in the other step.

The method for roughening the surface of the resin film 24 is not particularly limited, and can appropriately be selected in accordance with purposes, and there can be cited, for example, blast processing, embossing, and coating. As the arithmetic average roughness (Ra) of the coarse surface, there can be cited, for example, a value no lower than 1.0 µm and no higher than 2.0 µm.

Further, an average thickness of the resin film 24 is not particularly limited, and can appropriately be selected in accordance with purposes, and there can be cited, for example, a value no smaller than 10 µm and no larger than 100 µm.

Further, the temperature, the pressure, and the duration in the thermocompression bonding are not particularly limited, and can appropriately be selected in accordance with purposes. As the temperature, there can be cited, for example, a value no lower than 50 °C and no higher than 100 °C. As the pressure, there can be cited, for example, a value no lower than 0.5 MPa and no higher than 1.2 MPa. As the duration, there can be cited, for example, a value no less than 60 seconds and no more than 120 seconds under the temperature described above and the pressure described above.

It should be noted that in the thermocompression bonding, it is preferable to make the third insulating substrate 22 cure but not cure completely. Specifically, in the thermocompression bonding, it is preferable to make the third insulating substrate 22 not cure up to the C-stage, but cure up to the B-stage. This is because when via holes VH are formed in the third insulating substrate 22 after making the third insulating substrate 22 cure up to the B-stage, the dimensional stability of the via holes VH is enhanced. This is because when the plurality of laminates 30 is stacked, and then thermally compressed to form the circuit board 50 without making the third insulating substrates 22 completely cure up to the C-stage on the other hand, the adhesiveness between the third insulating substrate 22 of one laminate 30 and the second insulating substrate 20 of another laminate 30 is excellent. Further, this is because when the plurality of laminates 30 is stacked and then thermally compressed without making the third insulating substrates 22 completely cure up to the C-stage, the metal layer 18 of the laminate 30 at a position becomes apt to be embedded in the third insulating substrate 22 of another laminate 30, and thus, a circuit board homogenous in thickness can be obtained.

### <<<Via Formation Step>>>

Subsequently, the via formation step in the first step will be described. In the via formation step, the vias are formed from the surface at the opposite side to the first surface 14a side of the first insulating substrate 14 in the resin film 24 until the vias reach the metal layer 18.

As shown in Fig. 13, the via holes VH are formed from the surface at the opposite side to the first surface side of the first insulating substrate 14 in the resin film 24 until the via holes VH reach the metal layer 18.

The method for forming the via holes VH is not particularly limited, and can appropriately be selected in accordance with purposes, and there can be cited, for example, a perforation method using a laser.

Further, the laser is not particularly limited, and can appropriately be selected in accordance with purposes, and there can be cited, for example, a CO₂ laser and a YAG laser.

Further, the power of the laser is not particularly limited, and can appropriately be changed in accordance with purposes.

An opening size of the via holes VH is not particularly limited, as long as the surface at the first insulating substrate 14 side of the metal layer 18 is exposed, and can appropriately be selected in accordance with purposes, and can be, for example, no smaller than 50 µm and no larger than 500 µm, or can be no smaller than 100 µm and no larger than 300 µm. It should be noted that the opening size mentioned here means an opening size on, for example, the surface at the resin film 24 side of the third insulating substrate 22.

The shape of the via holes VH is not particularly limited, and can appropriately be selected in accordance with purposes, and there can be cited, for example, a shape (a taper shape) the diameter of which gradually decreases in a direction from the opening part at the resin film 24 side toward the metal layer 18.

The number of the via holes VH provided to one laminate 30 is not particularly limited, and can appropriately be selected in accordance with purposes.

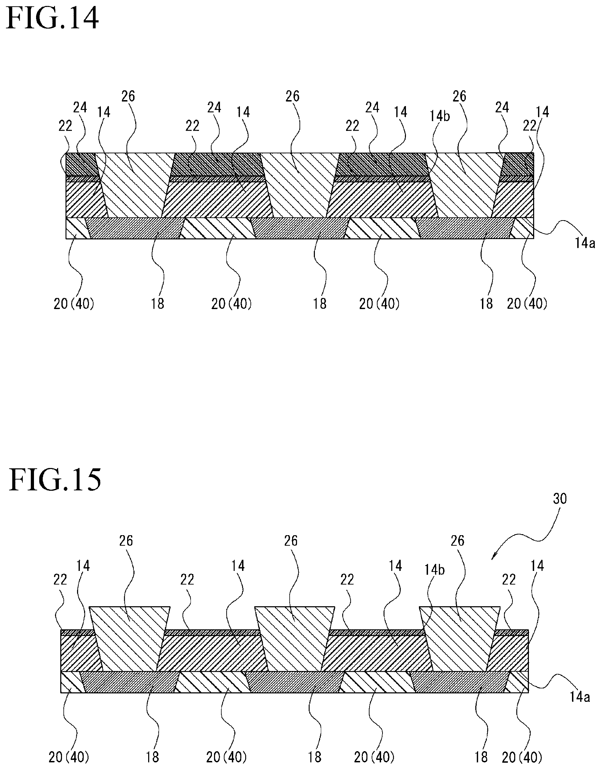

Subsequently, as shown in Fig. 14, each of the via holes VH is filled with a conductive paste 26.

The conductive paste 26 is not particularly limited, and can appropriately be selected in accordance with purposes, and there can be cited, for example, a conductive paste including metal particles (conductive filler) and binder resin.

As the metal constituting the metal particles, there can be cited, for example, copper, gold, silver, palladium, nickel, tin, lead, or bismuth. It is possible to use one of these alone, or to use two or more of these in combination.

As the binder resin, there can be cited, for example, thermosetting resin such as epoxy resin. It should be noted that the binder resin is not limited thereto, but the binder resin can also be other resin such as polyimide resin.

Further, the binder resin can take a liquid form or solid form at room temperature. When the binder resin takes the solid form at room temperature, the conductive paste 26 is heated to, for example, a temperature equal to or higher than the melting temperature of the binder resin, and is then used.

The conductive paste 26 can be a pressure contact type, or can also be a fusion type. It should be noted that the pressure contact type means a conductive paste in which a low-resistance metal powder (conductive filler) is not melted with a heat when stacked, but the conductive fillers have contact with each other only by the pressure when stacked to thereby enable the inter-layer conductive coupling. The pressure contact type loses the fluidity due to thermal curing of the resin included in the conductive paste. Further, the fusion type is a conductive paste in which a low melting-point metal powder (conductive filler) melts with the heat when stacked, and then cures so as to surround a high melting-point metal powder (conductive filler) to form an alloy layer to thereby enable the inter-layer conductive coupling.

The method for filling the via holes VH with the conductive paste 26 is not particularly limited, and can appropriately be selected in accordance with purposes, and there can be cited, for example, a method for filling the via holes VH with the conductive paste 26 under the atmospheric pressure or vacuum using a squeegee jig.

### <<<Separation Step>>>

Subsequently, the separation step in the first step will be described. In the separation step, the resin film 24 is separated.

The separation step is not particularly limited, and can appropriately be selected in accordance with purposes, and there can be cited, for example, a method for gripping an end portion of the resin film 24 with a jig, and then pulling the resin film 24 apart from the third insulating substrate 22. Due to the separation step, as shown in Fig. 15, the laminate 30 can be manufactured.

### <<<Surface Hardening Step>>>

It should be noted that it is preferable for the method for manufacturing the circuit board according to each of the embodiments to include a surface hardening step for hardening the surface of the conductive paste 26 protruding from the via holes of the laminate 30 as a preceding step to the second step.

Due to the surface hardening step, it is possible to keep the shape of the conductive paste 26 protruding from the via holes VH. Further, by hardening the surface of the conductive paste 26 protruding from the via holes VH, it is possible to prevent the conductive paste 26 from unnecessarily flowing to spread when stacking and then thermally compressing one laminate 30 and another laminate 30.

The degree of hardening in the surface hardening step is not particularly limited, and can appropriately be selected in accordance with purposes, and is not required to be complete hardening.

The degree of the heating in the surface hardening step is not particularly limited, and can appropriately be selected in accordance with purposes.

Due to the steps described above, the laminate 30 can be obtained. It should be noted that the laminate in the lowermost layer in the second step is a laminate 32 which does not include the second insulating substrate 20 (40) and the metal layer 18, but includes a metal foil 36 instead. The method for manufacturing the laminate 32 is not particularly limited, and can appropriately be selected in accordance with purposes, but it is possible to obtain the laminate 32 by, for example, preparing the first insulating substrate 14 to which the metal foil 36 is sticked, and then performing the second stacking step and the via formation step described above.

### <<Second Step>>

Subsequently, the second step of stacking a plurality of the laminates 30 will be described.

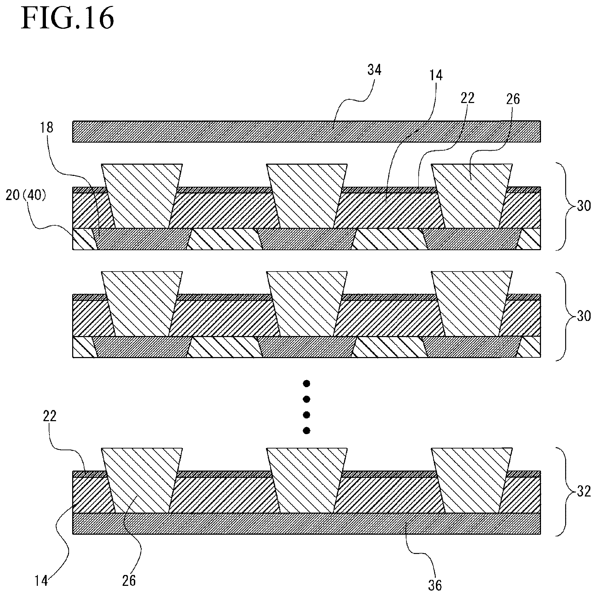

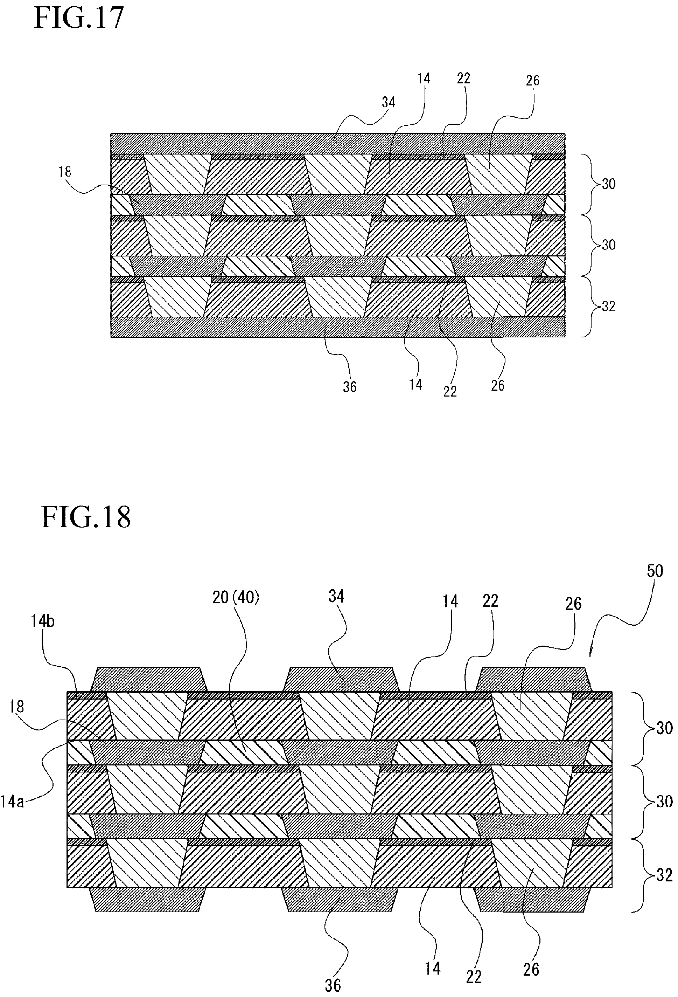

As the second step, one laminate 30 and another laminate 30 are stacked so that the metal layers 18 of the one laminate 30 and the opening parts of the via holes VH of the another laminate 30 are opposed to each other as shown in Fig. 16, and then the thermocompression bonding is performed thereon as shown in Fig. 17. It should be noted that a metal foil 34 is stacked on an upper surface of the laminate 30 in the uppermost layer. Further, the laminate 32 is stacked as the lowermost layer. As shown in Fig. 18, after the thermocompression bonding, by forming the metal foils 34, 36 to have predetermined patterns, the circuit board 50 can be obtained.

### <Circuit Board>

Subsequently, the circuit board 50 according to the present invention will be described. The parts and the members of the circuit board 50 are described in <Method for Manufacturing Circuit Board>, and therefore, the description thereof will be omitted here in some cases.

A schematic cross-sectional view of the circuit board 50 is shown in Fig. 18. The circuit board 50 includes at least a configuration in which a plurality of laminates 30 is stacked on one another, the laminates 30 each including the first insulating substrate 14, the metal layer 18 shaped like patterns and formed on the first surface 14a of the first insulating substrate 14, the second insulating substrate 20 (40) stacked to have the same thickness as that of the metal layer 18 in the places on the first surface 14a where the metal layer 18 is not disposed, the third insulating substrate 22 stacked on the second surface 14b at the opposite side to the first surface 14a of the first insulating substrate 14, and the vias 26 formed from the surface at the opposite side to the first insulating substrate 14 side of the third insulating substrate 22 until the vias 26 reach the metal layer 18, and the circuit board 50 further includes other constituents as needed.

Further, as the circuit board 50, more specifically, there is a configuration in which the metal layer 34, the plurality of laminates 30, and the laminate 32 are stacked in this order from the upper layer.

The metal layer 18 shaped like patterns is formed on the first surface 14a of the first insulating substrate 14, and at the same time, the second insulating substrate 20 (40) is also stacked thereon. In other words, gaps between the metal layers 18 formed to have patterns on the first surface 14a are filled with the second insulating substrate 20 (40) to form the second insulating substrate 20 and the metal layers 18 coplanar with each other.

Further, the via 26 is electrically coupled to the metal layer 18, the metal layer 34, or the metal layer 36. In Fig. 16, the cross-sectional area of the metal layer 18, 34, or 36 is made larger than the cross-sectional area of the via 26, but the sizes of the cross-sectional areas are not particularly limited as long as the via 26 and the metal layer 18, 34, or 36 are electrically coupled to each other, and can appropriately be selected in accordance with purposes.

Further, the vias 26 and at least the metal layer 18 in the laminate 30 may be formed so that the cross-sectional area decreases toward the same direction (i.e., the direction from the third insulating substrate 22 toward the second insulating substrate 20 (40), and the direction from the metal layer 34 toward the metal layer 36). More specifically, the vias 26 and at least the metal layer 18 in the laminate 30 may be formed to have a downward-facing trapezoidal shape (taper shape) in such a cross-sectional surface as shown in Fig. 18.

It should be noted that there is adopted the configuration in which the metal layer 34 as the uppermost layer and the metal layer 36 as the lowermost layer are exposed from the first insulating substrate 14 and the third insulating substrate 22. In other words, in the places where the metal layers 34, 36 are not disposed, the second insulating substrate 20 (40) is not stacked.

As the second insulating substrate, more specifically, it is preferable to adopt either one of the photosensitive resin film 20 and the photosensitive resin varnish 40.

Further, it is preferable for the surface at the second surface 14b side of the first insulating substrate 14 in the metal layer 18 to be subjected to the surface roughening treatment so that the arithmetic average roughness (Ra) is no lower than 1.0 µm and no higher than 2.0 µm. This causes an advantage that a resistance value abnormality and interlayer peeling are prevented from occurring between the metal layer 18 and the via 26 when stacking the plurality of laminates 30.

### <Electronic Device>

Subsequently, an electronic device 100 according to the present invention will be described. The electronic device 100 has at least the circuit board 50 and an electronic component, and further has other members as needed.

The electronic device 100 is not particularly limited, and can appropriately be selected in accordance with purposes. There can be cited, for example, a personal computer (a notebook personal computer, a desktop personal computer), a telephone set, a cellular phone, a tablet portable terminal, a smartphone, a copy machine, a facsimile, a variety of types of printers, digital camera, a television set, a video recorder, a CD player, a DVD player, an air conditioner, and a remote controller.

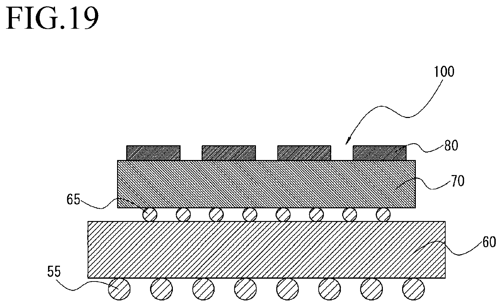

A schematic cross-sectional view of a semiconductor package is shown in Fig. 19. The semiconductor package shown in Fig. 19 has a motherboard 60 including solder balls 55, an interposer 70 coupled on the motherboard 60 via bumps 65, and semiconductor elements 80 arranged on the interposer 70. As the semiconductor elements 80, there can be cited, for example, an FPGA (Field Programmable Gate Array) chip.

Here, the circuit board 50 can be used as the motherboard 60 in Fig. 19, can be used as the interposer 70, and further, can be used as a circuit board constituting the semiconductor element 80.

## Claims

1. A circuit board **characterized in that**
a plurality of laminates which include a first insulating substrate, a metal layer formed on a first surface of the first insulating substrate to have a pattern, a second insulating substrate stacked in a place of the first surface where the metal layer is not disposed so as to have a same thickness as the metal layer, a third insulating substrate stacked on a second surface at an opposite side to the first surface of the first insulating substrate, and a via formed from a surface at an opposite side to the first insulating substrate side of the third insulating substrate until the via reaches the metal layer, is stacked.

2. The circuit board according to claim 1 **characterized in that**
the metal layer and the via are formed so as to decrease in cross-sectional area in a direction from the third insulating substrate toward the second insulating substrate.

3. The circuit board according to claim 1 or 2 **characterized in that**
the second insulating substrate is formed of one of a photosensitive resin film and a photosensitive resin varnish.

4. The circuit board according to claim 1 or 2 **characterized in that**
a surface at the second surface side in the metal layer is subjected to a surface roughening treatment so as to have an arithmetic average roughness (Ra) no lower than 1.0 µm and no higher than 2.0 µm.

5. A method for manufacturing a circuit board **characterized by** comprising:
a first step of forming a laminate with a metal layer formation step of forming a metal layer on a first surface of a first insulating substrate to have a pattern, a first stacking step, as a subsequent step, of stacking a second insulating substrate to have a same thickness as the metal layer in a place of the first surface where the metal layer is not disposed, to expose a surface of the metal layer, a second stacking step, as a subsequent step, of stacking a third insulating substrate which is uncured and a resin film in this order on a second surface at an opposite side to the first surface of the first insulating substrate, a via formation step, as a subsequent step, of forming a via from a surface at an opposite side to the first insulating substrate side of the resin film until the via reaches the metal layer, and a separation step, as a subsequent step, of separating the resin film; and
a second step of stacking a plurality of the laminates.

6. The method for manufacturing the circuit board according to claim 5 **characterized by** including
a surface roughening step, as a subsequent step to the first stacking step, of performing a surface roughening treatment on a surface at an opposite side to the first surface side in the metal layer to have an arithmetic average roughness (Ra) no lower than 1.0 µm and no higher than 2.0 µm.

7. The method for manufacturing the circuit board according to claim 5 or 6 **characterized in that**
the second insulating substrate is formed of a photosensitive resin film, and
the first stacking step includes a step of attaching the photosensitive resin film so as to cover the metal layer from the first surface side, and a step of making the metal layer and the photosensitive resin film coplanar with each other.

8. The method for manufacturing the circuit board according to claim 5 or 6 **characterized in that**
the second insulating substrate is formed of a photosensitive resin varnish, and
the first stacking step includes a step of printing the photosensitive resin varnish so as to cover the metal layer from the first surface side, and a step of making the metal layer and the photosensitive resin varnish coplanar with each other.

9. An electronic device **characterized by** comprising:
the circuit board according to claim 1 or 2; and an electronic component.
